# EUROPEAN PATENT APPLICATION

(11) **EP 3 863 030 A1**
(43) Date of publication of application: **11.08.2021**
(21) Application number: 20155373.2
(22) Date of filing: 04.02.2020
(51) Int. Cl.: H01F 1/24, H01F 1/26, H01F 38/14, H01F 17/06, H05K 1/18

(54) **SUBSTANTIALLY ANNULAR MAGNETIC MEMBER WITH MAGNETIC PARTICLES IN NON-MAGNETIC MATRIX FOR COMPONENT CARRIER**

(71) Applicant: AT & S Austria Technologie & Systemtechnik Aktiengesellschaft, 8700 Leoben-Hinterberg (AT)
(72) Inventor: Weidinger, Gerald, 8700 Leoben (AT); Weis, Gerald, 8641 St. Marein im Mürztal (AT); Salkovic, Ivan, 10020 Zagreb (HR)
(74) Representative: Dilg, Haeusler, Schindelmann Patentanwaltsgesellschaft mbH

(57) **Abstract**

A magnetic member (108) having a substantially annular structure and comprising a non-magnetic matrix (160) and magnetic particles (162) embedded in the matrix (160).

## Description

### Field of the Invention

The invention relates to a magnetic member, to a component carrier, to a method of manufacturing a component carrier, and to a method of use.

### Technological Background

In the context of growing product functionalities of component carriers equipped with one or more electronic components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

In particular, providing a component carrier or other electronic devices with properly defined magnetic properties is an issue.

### Summary of the Invention

There may be a need to provide a component carrier or other electronic devices with properly defined magnetic properties.

According to an exemplary embodiment of the invention, a magnetic member is provided having a substantially annular structure and comprising a non-magnetic matrix and magnetic particles embedded in the matrix.

According to another exemplary embodiment of the invention, a component carrier is provided which comprises a stack comprising at least one electrically conductive layer structure and/or at least one electrically insulating layer structure, and a magnetic member having the above-mentioned features and being assembled to the stack.

According to still another exemplary embodiment of the invention, a method of manufacturing a magnetic member is provided, wherein the method comprises embedding magnetic particles in a non-magnetic matrix, and shaping or configuring the magnetic member so as to form a substantially annular structure.

According to yet another exemplary embodiment of the invention, a magnetic member having the above-mentioned features is used for adjusting magnetic properties of a component carrier.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "layer structure" may particularly denote a continuous layer, a patterned layer or a plurality of nonconsecutive islands within a common plane.

In the context of the present application, the term "member" may particularly denote a pre-manufactured element which can be readily manufactured in accordance with the requirements of its function, independently of boundary conditions of component carrier manufacturing technology. A member may be a single integral body (such as a closed ring) or a ring with one gap, or may be an arrangement of several individual bodies (for instance a number of ring segments which can be arranged in an annular way with gaps in between), which may be arranged in a functionally cooperating way.

In the context of the present application, the term "magnetic member" may particularly denote a member comprising magnetic material. A magnetic member may be composed of one or multiple connected or spaced magnetic elements. Such one or more magnetic elements may function as a magnetic core and may increase the magnetic field and thus the inductance of an inductor.

In the context of the present application, the term "non-magnetic matrix" may particularly denote a binder constituent in the composite material forming the substantially annular structure of the magnetic member. The matrix material may be substantially non-magnetic, in particular may have a relative magnetic permeability which is very close to one. For instance, the non-magnetic material may have diamagnetic properties or may have (preferably weak) paramagnetic properties. In particular, the non-magnetic material does not have permanent magnetic or ferromagnetic properties.

In the context of the present application, the term "magnetic particles" may particularly denote a large plurality of separate particles (in particular at least 100 particles, preferably at least 1000 particles) in the integral non-magnetic matrix. In particular, said magnetic particles may be powder particles, beads, pellets, flakes, spheres, or any other kind of ordered or randomly shaped particles. The magnetic particles may have a higher, in particular significantly higher, relative magnetic permeability than the non-magnetic material of the matrix. In particular, the material of the magnetic particles may have permanent magnetic or ferromagnetic properties. For instance, the particles may be of different shapes like flakes, spheres, irregular spheres, polygons.

In the context of the present application, the term "substantially annular structure" may particularly denote a ring shape of the matrix with the embedded particles with at least one opening, in particular with a central through hole. This may for instance establish at least one essentially closed path of a magnetic field within the annular structure. However, the substantially annular structure may also be interrupted by one or more preferably narrow but macroscopic air gaps. The substantially annular structure may in particular have an open ring-shape or a closed ring shape. For example, a substantially annular structure may also be a double ring. For instance, the annular structure may have a circular shape, a rectangular shape, a square shape, a disc shape, a UU shape, a UI shape, an EI shape, a TI shape, an EE shape, etc. Furthermore, other possible variants of such a substantially annular structure may be an E shape, an EFD shape, an ETD shape, an EER shape, an EP shape, a planar shape, a PQ shape, an RM shape, a U shape, a UYF shape, an EPC shape, a PTS shape, a P shape, a T shape, a PQI shape, an EC shape, a URS shape, an ECW shape, an H shape, a Z shape, and a pot core shape. The substantially annular structure may also assume many other shapes. In particular, the term "substantially annular" may cover all forms that form a closed or only partially interrupted structure with hole, for instance those according to the given examples.

According to an exemplary embodiment of the invention, a magnetic member or inlay is provided which is composed of a non-magnetic matrix (for instance made of resin) with a large plurality of (for instance powderous or flake-type) magnetic particles therein. It has been surprisingly found that the non-magnetic matrix spacing embedded magnetic particles functionally behaves very similar as a macroscopic air gap in an annular magnetic structure. Descriptively speaking, the (for instance resin) matrix emulates or mimics an air gap, so that characteristics of the non-magnetic matrix may be used as design parameters for adjusting or fine tuning the magnetic properties of the magnetic inlay, in particular in terms of saturation and/or stability. Furthermore, the opportunity to optionally omit one or more macroscopic gaps along a perimeter of the magnetic member due to the formation of a large plurality of microscopic gaps between the magnetic particles in the non-magnetic matrix may advantageously suppress undesired fringing effects, i.e. magnetic loss effects accompanied by the formation of hot spots.

When assembling (in particular surface mounting or preferably embedding) such a magnetic member to a stack of a component carrier (such as a printed circuit board), the non-magnetic (and in many cases electrically insulating) matrix may synergistically function as (preferably dielectric) barrier with respect to electrically conductive material within the stack of the component carrier. Moreover, the option to omit macroscopic air gaps in a circumferential direction of the annular magnetic member may render the component carrier as a whole mechanically more stable and thus more reliable during operation, since this may suppress the tendency of the formation of undesired voids in the interior of the component carrier.

### Detailed Description of Exemplary Embodiments

In the following, further exemplary embodiments of the magnetic member, the component carrier and the methods will be explained.

In an embodiment, the matrix is electrically insulating. In such embodiments, the matrix may fulfil a double function. On the one hand, the matrix may form microscopic or intrinsic non-magnetic gaps allowing to adjust the desired magnetic properties of the magnetic member, in particular its saturation properties. Simultaneously, the matrix may also function for electrically decoupling electrically conductive structures surrounding the magnetic member in the component carrier from the (for instance electrically conductive) magnetic particles of the magnetic member. This may advantageously avoid the formation of undesired electrically conductive paths in an interior of the component carrier or another electronic environment of the magnetic member.

In an embodiment, the matrix is diamagnetic. Diamagnetism may be denoted as the property of an object which causes it to create a magnetic field in opposition of an externally applied magnetic field, thus causing a repulsive effect. Specifically, an external magnetic field alters the orbital velocity of electrons around their nuclei, thus changing the magnetic dipole moment in the direction opposing the external field. Diamagnets are materials with a relative magnetic permeability µᵣ less than 1).

In an embodiment, the relative magnetic permeability µᵣ of the matrix is in a range from 0.999 to 1.001, in particular in a range from 0.9999 to 1.0001. Diamagnets are materials with a relative magnetic permeability µᵣ less than 1. Paramagnetic materials have a relative magnetic permeability µᵣ greater than 1. In view of the above mentioned ranges, the material of the matrix may have very weak magnetic properties with a value of the relative magnetic permeability µᵣ very close to 1.

In an embodiment, the matrix comprises or consists of at least one of the group of temperature stable polymers or resins, e.g. an epoxy resin or a polyimide. Examples of suitable temperature stable polymers are a thermoset organic resin in particular an epoxy resin, bismaleinimide-trianzine, cyanate ester or polyimide, a thermoplastic polymer (in particular polyimide), polytetrafluoroethylene (PTFE), liquid crystal polymer (LCP), polyamide, Cyclo-olefinic Copolymer (COC) or Polyetherimide, a thermoplastic material, in particular Polyolefins such as Polypropylene (PP), Vinyl-Polymers such as PVC, Styrene based Polymers such as Polystyrene (PS), Polyacrylates such as Polymethylmethacrylate (PMMA), Polyacetals such as Polyoxymethylene (POM), Fluoropolymers such as Polytetrafluoroethylene (PTFE), Polyamides including aromatic polyamides such as Polyphthalamide (PPA), Polycarbonate (PC) and Derivatives, Polyesters such as Polyethylene terephthalate (PET), Liquid Crystalline Polymers (LCP), Polyarylether such as Polyphenyleneether (PPE), Polyphenylenesulfone (PSU), Polyarylethersulfone (PES), Polyphenylensulfid (PPS), Polyetherketones such as Polyetheretherketone (PEEK), Polyimide (PI), Polyetherimide (PEI), or Polyamideimide (PAI). In particular when the matrix comprises an epoxy resin, the material properties of the matrix and also of the magnetic member as a whole may be quite similar to the material properties of the surrounding component carrier stack which may have electrically insulating layer structures (for instance of prepreg) also comprising epoxy resin. This may advantageously reduce a CTE (coefficient of thermal expansion) mismatch as well as dielectric material bridges in an interior of the component carrier. Also polyimide may properly match with other dielectric stack material.

In an embodiment, the matrix is solid and/or liquid. In particular, the material of the matrix may be already cured and thus solid, or may be liquid and still curable, for instance by the application of heat and/or pressure. Curing may trigger the material to polymerize and/or cross-link and/or may promote evaporation of solvent.

In an embodiment, the magnetic particles are at least one of the group consisting of ferromagnetic, ferrimagnetic, permanent magnetic, soft magnetic, a ferrite, a metal oxide, and iron-based with additive (in particular with silicon additive). For instance, an iron alloy may be appropriate, in particular alloyed silicon. In particular, the magnetic particles may be made of a soft magnetic material, in particular a ferrite. A ferrite may be a ceramic material which may be made by mixing and firing large proportions iron oxide (Fe₂O₃) blended with small proportions of one or more additional metallic elements, such as manganese, nickel, etc. Ferrites may be electrically insulating and ferrimagnetic. In particular, the magnetic particles may comprise soft ferrite which have low coercivity, so it may easily change its magnetization. This may be in particular advantageous for applications such as high-frequency inductors and transformers. It is also possible to use ferrite platelets or flakes for manufacturing ferrite particles. However, in other exemplary embodiments, the magnetic particles may be made of other magnetic materials, in particular ferromagnetic or ferrimagnetic or paramagnetic materials.

In an embodiment, the relative magnetic permeability µᵣ of the magnetic particles is in a range from 2 to 1,000,000. For instance for low loss applications, the relative magnetic permeability µᵣ of the magnetic particles may be in a range from 2 to 100. For high-power applications, the relative magnetic permeability µᵣ of the magnetic particles may be in particular in a range from 50 to 500. For shielding applications, the relative magnetic permeability µᵣ of the magnetic particles may be preferably in a range from 500 to 1,000,000. Thus, the magnetic particles of the magnetic member may have the capability of strongly enhancing a magnetic field applied for instance externally by a coil structure through which an electric current flows.

In an embodiment, the magnetic particles are magnetically stable at least up to 200°C, in particular at least up to 260°C. In other words, the magnetic properties as well as the mechanical integrity of the magnetic particles may remain intact even when heated up to 200°C or preferably up to 260°C. For instance, the mentioned temperatures are typical temperatures occurring during lamination of layer structures of a stack of a component carrier such as a PCB. Hence, when the magnetic particles are temperature stable to the described extent, the magnetic member may be properly embedded in a stack of the component carrier by lamination.

In an embodiment, the magnetic particles are spaced with respect to each other with material of the matrix in between. More generally, at least part of the magnetic particles (in particular at least 50%, more particularly at least 80%, preferably at least 90%, of the magnetic particles) may be spaced with respect to each other without direct physical contact with other magnetic particles, and with material of the matrix in between adjacent ones of said spaced magnetic particles. Preferably, the magnetic particles are thus separated from each other by material of the matrix. For instance, at least a majority of the magnetic particles may be free of a direct physical contact with neighboured magnetic particles within the matrix. Under such conditions, a plurality of microscopic non-magnetic gaps may be formed by matrix material in between the different magnetic particles. This allows properly adjusting the magnetic properties of the magnetic member without the absolute need of creating macroscopic air gaps within the annular magnetic member.

In an embodiment, the magnetic particles comprise a magnetic core and an electrically insulating shell covering the magnetic core. By coating magnetic cores (which may for instance be electrically conductive) with dielectric shells, the formation of any undesired electrically conductive paths by the magnetic particles in an interior of the component carrier or in another electronic environment may be reliably prevented.

In an embodiment, substantially an entire exterior surface of the substantially annular structure is electrically insulating. This may ensure that no undesired electrically conductive paths are erroneously formed when the magnetic member is embedded or connected to an electronic environment, for instance a printed circuit board. This may be accomplished by ensuring that electrically insulating matrix material forms substantially the entire exterior surface of the annular structure of the magnetic member. It is also possible that the matrix with embedded magnetic particles is surrounded with an electrically insulating shell.

In an embodiment, the magnetic member is a closed ring, i.e. without any microscopic air gaps. When the magnetic member is configured as closed ring, the embedding of the magnetic member is very simple, since only a single piece needs to be handled and assembled when mounting the magnetic member in a cavity of the stack. Magnetic properties might be fine-tuned by configuring properties of the matrix and the magnetic particles. Furthermore, the risk of forming undesired voids in an interior of the component carrier may be avoided when omitting microscopic gaps. This may increase the mechanical integrity and thus the reliability of the component carrier.

In another embodiment, the magnetic member is a ring structure composed of a plurality of ring segments with one or at least two gaps in between. For example, said no more macroscopic gaps may be air gaps or may be gaps filled with dielectric material. For instance, three ring segments of a magnetic member may be arranged with three gaps in between and enclosing a central opening. Advantageously, it may be possible that the magnetic member has an annular structure which is however separated at one or multiple positions along its circumference so that preferably a plurality of gaps is formed around the circumference. For instance, one, two, three or even more gaps may be formed. Generally speaking, a few small air gaps may be preferred over one large air gap. While a gap is normally considered as a loss mechanism, the provision of one or a plurality of sufficiently tiny gaps has nevertheless the advantage that it can be used as a design parameter for adjusting or fine-tuning the magnetic properties of the magnetic member. In particular, substantially homogeneous magnetic properties may be obtained when distributing multiple gaps substantially equally distributed along a perimeter of the annular magnetic member. When having one or more macroscopic air gaps, the magnetic properties of the magnetic member can be adjusted particularly accurately using two different sets of design parameters, i.e. design parameters related to the one or more macroscopic gaps and additional design parameters related to the design of the non-magnetic matrix and the magnetic particles.

In an embodiment, the magnetic member is configured for generating or forming a circumferentially closed magnetic field substantially in an interior of the magnetic member. When the magnetic member is substantially circumferentially closed, a coil structure wound around the essentially annular magnetic member with a circumferentially closed coil axis may create a magnetic field in an interior of the substantially annular magnetic member with closed and for instance substantially circular field lines. Such a configuration may be advantageous, for instance when the magnetic member is configured as inductor.

In an embodiment, the magnetic member itself (i.e. even apart from or outside of a stack of a component carrier) may comprise an electrically conductive coil structure at least partially surrounding the annular structure. Therefore, the coil structure, which may be for instance a helically wound multi-winding electric wire, may form an integral part of the magnetic member. Powering the coil structure with an electric current may provide a high-inductance function of the magnetic member.

In an embodiment, the magnetic member is surface mounted on the stack. Hence, the magnetic member may be employed as a surface mounted device (SMD).

In a preferred embodiment, the magnetic member may however be embedded in the stack. By embedding the magnetic member, a highly compact component carrier may be provided with sophisticated magnetic functionality. Synergistically, electrically conductive stack material may be used for forming a coil structure surrounding the magnetic member, which may further promote the compactness of the component carrier.

Thus, the component carrier may comprise an electrically conductive coil structure at least partially surrounding the magnetic member and being arranged at least partially (preferably entirely) within the stack. In the context of the present application, the term "coil structure" may particularly denote an at least partially electrically conductive structure, which may be composed of interconnected electrically conductive elements, defining one or multiple windings. The windings may have a circular shape, a rectangular shape, any other polygonal shape, etc. A coil structure may have the electric function of an electrically conductive coil. Preferably, the at least one electrically conductive layer structure of the stack forms at least part of the coil structure. In such an embodiment, a component carrier is provided which has an embedded magnetic member being surrounded by a coil structure which is made of intrinsic electrically conductive component carrier material. In other words, the electrically conductive layer structures which also form traces, vertical through-connections, pads, etc. of the component carrier may also be configured so as to form together an electrically conductive coil structure with multiple windings, or at least part thereof. In particular, an inductor with a member type magnetic core may be provided in which only the core needs to be embedded in the stack as the magnetic member, wherein the coil structure is formed by electrically conductive material of the laminated stack. By taking this measure, it may be possible to manufacture the component carrier with very low effort and without introducing additional material bridges in an interior thereof.

In an embodiment, the coil structure comprises a plurality of vertical segments and a plurality of horizontal segments connected to form a plurality of windings. Thus, the integrated coil structure may be formed by connecting a plurality of vertically extending segments of electrically conductive material (such as copper) being connected with a plurality of correspondingly formed horizontal sections of electrically conductive material (such as copper). The various horizontal and vertical sections or segments may be interconnected so as to form altogether a plurality of windings. For instance, said windings may be arranged in a donut shape or in other words as windings being circumferentially arranged around a central axis of an annular magnetic member.

In an embodiment, the vertical sections comprise plated through-holes or slots filled with electrically conductive material. The vertical segments may be formed for instance by mechanically drilling or laser drilling, followed by the filling of correspondingly formed drilling holes with an electrically conductive material for instance by plating. While the vertical segments may have a substantially cylindrical geometry, they may also be slits or slots. Highly advantageously, the vertical segments may be formed as slots filled with electrically conductive material such as copper. Such slots may be cut or drilled into the stack and may be filled substantially with copper. With such slots, particularly advantageous low ohmic properties may be obtained.

In an embodiment, the horizontal segments are located in two parallel planes between which the vertical segments are connected. The horizontal segments may be formed by attaching and patterning a first metallic foil above the magnetic member and a second magnetic foil below the magnetic member. In particular, the horizontal segments may be coplanar, i.e. may extend in two horizontal planes spaced by the magnetic member. Also this contributes to highly advantageous magnetic properties of the combined magnetic member and integrated coil structure of the component carrier.

In an embodiment, the horizontal segments extend radially outwardly with respect to a common centre. Said centre may correspond to a central axis of an annular magnetic member. Such a geometry forms the basis for circumferential windings of a for instance substantially donut-shaped coil structure.

In an embodiment, the horizontal segments are substantially triangular. The horizontal segments may for instance be substantially triangular sectors of a circle. This may ensure a low ohmic configuration.

In an embodiment, the method comprises adjusting the magnetic properties by adjusting a relative amount (in particular volume and/or mass) of the magnetic particles and/or a relative amount (in particular volume and/or mass) of the matrix, a size (in particular particle diameter) and/or a mutual distance between the magnetic particles in the matrix. For instance, the magnetic particles may contribute 50 to 98 weight percent of the annular structure, in particular 70 to 90 weight percent of the annular structure. For example, the matrix may contribute 2 to 50 weight percent of the annular structure, in particular 10 to 30 weight percent of the annular structure. When no additives (which may however be optionally present) are present in the annular structure, the weight percentages of the matrix and the magnetic particles may sum up to 100 weight percent. When one or more additives are present in the annular structure, the weight percentages of the matrix and the magnetic particles and the one or more additives may sum up to 100 weight percent. For instance, a diameter of the magnetic particles may be in a range from 0.1 µm to 100 µm, in particular from 1 µm to 100 µm, for instance around 30 µm. For instance, an average distance between adjacent magnetic particles may be in a range from 0.1 µm to 50 µm, in particular from 1 µm to 10 µm.

In an embodiment, the component carrier is configured as one of the group consisting of an inductor, a wireless charger, a transformer, and a DC/DC converter. It is also possible that the component carrier is configured as an AC-DC inverter, a DC-AC inverter or an AC-AC converter.

What concerns the wireless charging function of the component carrier, applying an electric current to the coil structure generates an electromagnetic field in the environment of the component carrier. The magnetic member of very high magnetic permeability enhances the electromagnetic field. When a mobile phone or other electronic device to be charged in a wireless manner is positioned in an environment of the component carrier and when such an electronic device comprises a corresponding receiver unit, the electromagnetic field generated by the component carrier may be used for charging the electronic device.

In the context of the present application, the term "inductor" may particularly denote a passive (in particular two-terminal) electrical component that is capable of storing energy in a magnetic field when electric current flows through the inductor. An inductor may comprise an electrically conductive wiring wound into a coil shape around a magnetic core. When an inductor shall be embedded, a single coil structure may surround the magnetic member.

In an embodiment, two inductors may be magnetically coupled as a transformer. For this purpose, an inductor and a further inductor may cooperate to transfer electrical energy between different circuits through electromagnetic induction. In case of a transformer, the magnetic member may have multiple vertical post-like structures connected by horizontally extending magnetic bars, wherein two coil structures are wound around different ones of the vertical posts, to thereby form a primary winding and a secondary winding of the transformer. Hence, even more sophisticated magnetic functions than those of an inductor may be provided by the component carrier with embedded magnetic member and intrinsic coil structure.

In particular when the magnetic member is configured as a transformer, a lot of heat may be emitted by the coil structure. This is based on a high current density passing through the coil structure simultaneously generating a significant amount of heat. Therefore, it may be advantageous to include a heat spreading layer or any other kind of heat removal structure in the stack, in particular close to the heat generating coil structure. Such a heat spreading layer can be made out of a metal, like copper, or it can be made out of a thermally conductive prepreg where the resin contains a filler with high thermal conductivity (such as aluminium oxide or aluminium nitride).

In other embodiments, three or even six inductors of a component carrier may be magnetically coupled, for instance for a DC to DC converter, a DC to AC converter or motor drives.

In an embodiment, the component carrier comprises a plurality of magnetic members having the above-mentioned features. Each of said magnetic member may be embedded in a respective one of multiple stacked cores of the component carrier.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The stack may be a laminated stack, i.e. formed by connecting its layer structures by the application of heat and/or pressure.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias as through hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Size Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene-functionalized polymers.

In an embodiment, the at least one electrically insulating layer structure comprises at least one of the group consisting of resin (such as reinforced or non-reinforced resins, for instance epoxy resin or bismaleimide-triazine resin), cyanate ester resin, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (PTFE, Teflon), a ceramic, and a metal oxide. Reinforcing structures such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, at least one of the electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be optionally surface mounted on and/or embedded in the stack, can be selected from a group consisting of an electrically non-conductive member, an electrically conductive member (such as a metal member, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 to Figure 3 illustrate different views of magnetic members with magnetic particles in a non-magnetic matrix according to exemplary embodiments of the invention.
Figure 4 to Figure 6 illustrate cross-sectional views of transformers produced using magnetic members and coil structures according to exemplary embodiments of the invention.
Figure 7 to Figure 16 illustrate cross-sectional views of structures obtained during manufacturing a component carrier, shown in Figure 16, with an embedded magnetic member such as the one shown in Figure 1 to Figure 3 and an intrinsically formed coil structure according to an exemplary embodiment of the invention.
Figure 17 to Figure 19 illustrate plan views of component carriers according to exemplary embodiments of the invention having a magnetic member such as the one shown in Figure 1 to Figure 3.
Figure 20 and Figure 21 illustrate three-dimensional views of component carriers having a magnetic member such as the one shown in Figure 1 to Figure 3 according to exemplary embodiments of the invention.
Figure 22 to Figure 24 illustrate plan views of inductor structures having a magnetic member such as the one shown in Figure 1 to Figure 3 which may be implemented in component carriers according to exemplary embodiments of the invention.
Figure 25 to Figure 30 illustrate cross-sectional views of structures obtained during manufacturing a component carrier, shown in Figure 30, with an embedded magnetic member such as the one shown in Figure 1 to Figure 3 and an intrinsically formed coil structure according to another exemplary embodiment of the invention.
Figure 31 to Figure 39 illustrate cross-sectional views of structures obtained during manufacturing a component carrier, shown in Figure 39, with an embedded magnetic member such as the one shown in Figure 1 to Figure 3 and an intrinsically formed coil structure according to still another exemplary embodiment of the invention.
Figure 40 to Figure 47 illustrate cross-sectional views of structures obtained during manufacturing a component carrier, shown in Figure 47, with an embedded magnetic member such as the one shown in Figure 1 to Figure 3 and an intrinsically formed coil structure according to yet another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, component carrier applications (in particular PCB based applications) may be accomplished with embedded magnetic materials with intrinsic non-magnetic (in particular polymer-filled (microscopic) air gaps. In particular, an exemplary embodiments may use magnetic particles surrounded with a polymer matrix, which acts as intrinsic air gap. Particle-type magnetic material with intrinsic air gaps formed by non-magnetic matrix material may make it possible to achieve magnetic properties which may be specifically in compliance with a certain application. Thus, the present inventors have surprisingly found that polymer composites with a plurality of magnetic particles therein may provide intrinsic air gap properties. This may also provide a wide range of design parameters for fine-tuning the magnetic properties of a corresponding magnetic member.

Advantageously, microscopic air gaps may be used to stabilize the behavior of the magnetic member over electric current. Said microscopic or distributed air gaps may additionally be much better in terms of magnetic field fringing (i.e. a phenomenon according to which a magnetic field is running out of the core) than macroscopic gaps in a ring-shaped magnetic member. Moreover, the flexibility of adjusting the magnetic properties of the magnetic member by the adjustment of one or more dedicated or macroscopic air gaps and/or by the adjustment of distributed or microscopic air gaps may significantly increase the flexibility of a component carrier designer. In particular for high current magnetic applications, an adjustment of the magnetic properties may be accomplished according to exemplary embodiments of the invention by correspondingly designing the dedicated and/or the distributed air gaps. For low current magnetic applications (for instance involving electric current below 1 Ampere), dedicated or macroscopic air gaps may also be completely omitted. According to an exemplary embodiment of the invention, a component carrier (in particular a PCB, printed circuit board) with embedded magnetic material having intrinsic polymer-filled air gaps is provided.

Advantageously, a non-conductive coating around each magnetic particle may increase the resistivity of the magnetic material and may improve the air gap properties as well as the electrical isolation against electrically conductive structures.

If a temperature stable polymer is used as a binder, i.e. as material for the matrix, reliability of the magnetic member and a component carrier implementing such a magnetic member may be improved.

In particular, exemplary embodiments can be used to create PCB-based magnetic components for the following applications: Wireless charging (both transmitter and receiver) units, power transformers for isolated power supplies, power inductors for non-isolated power supplies, shielding layers, antenna configurations, signal transformers, common mode chokes, differential mode chokes, current sense transformers, RFID devices, and NFC devices. In particular, embedding magnetic materials in a non-magnetic matrix into a component carrier stack may allow the production of inductors and transformers for PCB-based power modules as well as sensors, wireless charging units and other applications.

Since material in a surrounding of the magnetic member (for instance electrically conductive layer structures of a component carrier stack in which the magnetic member is embedded) can be electrically conductive, it may be advantageous that the magnetic particles are electrically isolated from such electrically conductive structures (for instance from copper in a PCB). This may be accomplished by a dielectric matrix of the annular structure.

For designing embedded inductors and transformers in terms of component carrier technology, PCB production processes may employ the formation of coils around an embedded magnetic inlay in inner layers of a PCB stack. However, magnetic materials may go into saturation when used at higher magnetic field strength. This may render it advantageous to introduce one or more air gaps into the magnetic core. The present inventors have surprisingly found that the space between magnetic particles filled with non-magnetic matrix material (for instance a polymer) may act as an intrinsic air gap. Since usable magnetic materials may be electrically conductive to a certain extent, it may be advantageous to electrically insulate the magnetic material against electrically conductive structures in a surrounding of the magnetic member. For instance, this may be accomplished by dielectric matrix material, a coating of the magnetic particles with a dielectric shell, the lamination of electrically isolating layers on both sides of the annular structure of the magnetic member to isolate against the conductive layers structures, and/or the formation of conductive vias and through holes which may be isolated by via-in-via technology.

In particular, it may be possible to embed the described magnetic material as inlay, but it may also be provided as continuous layer (which may for instance be embedded in a stack of a component carrier as a whole).

Depending on an application, surface-mounted magnetic components may be considered as largest components inside power modules. By having magnetic material embedded in inner layers of a component carrier such as a PCB, it may be possible to make conductive structures around the magnetic material to create coils for different applications. Magnetic materials may go into saturation when used at higher magnetic field strength compared to those for which the magnetic materials are initially designed. Since an application may require high magnetic field strength, it may be advantageous to introduce one or more air gaps into the magnetic core to prevent the magnetic material from going into saturation, which may deteriorate or even reversibly destroy magnetic properties.

The present inventors have surprisingly found that the space between magnetic particles filled with polymer material may functionally act as an intrinsic air gap. If such materials are used, an additional air gap cut into the core shape may be dispensable for the device to function as intended. Different materials have been tested which has confirmed this conclusion.

Another conventional shortcoming which may be overcome by exemplary embodiments of the invention is the issue that some of the materials are electrically conductive to a certain extent (due to low resistivity of the magnetic material), so it may be advantageous that the magnetic layer is isolated against the conductive structures. This may be achieved by laminating insulating layers on both sides of the magnetic layer to isolate them against the conductive layer in the build-up. If continuous magnetic layers are used, conductive vias and through holes passing through the magnetic layer need to be isolated by via-in-via technology.

Magnetic material can be embedded as an inlay, as a continuous layer or in combination with other components. The height of the magnetic material can be adopted to the height of one or more optional other embedded components (actives and/or passives).

A gist of an exemplary embodiment of the invention is thus the use of magnetic materials based on magnetic particles surrounded by a non-magnetic (for instance polymer) matrix, which functionally acts as intrinsic air-gap. Moreover, a further exemplary aspect is the introduction of isolation layers to realize a PCB build-up with embedded magnetic inlay. Furthermore, another exemplary aspect is the use of embedding technology to realize target applications in case when prefabricated inlays are used. Highly advantageously, the described magnetic material with intrinsic air gaps may make it possible to achieve desired magnetic properties adjusted in accordance with the requirements of a specific application.

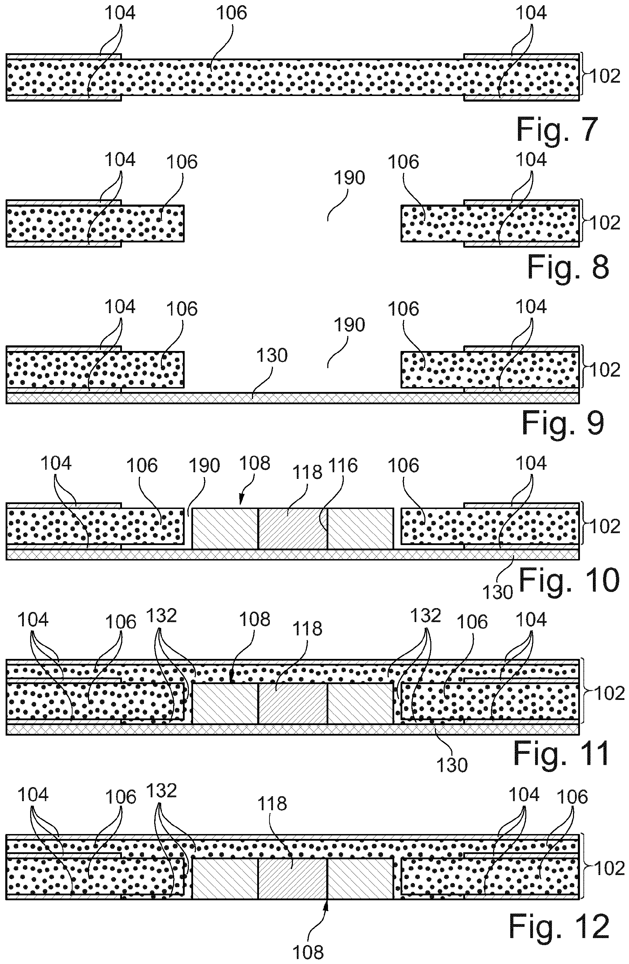

For instance, an embedding method (see Figure 7 to Figure 16) may be used to embed one or more pre-fabricated magnetic inlays (with non-magnetic matrix and magnetic particles embedded therein) into the inner layers of a PCB. Then, electrically conductive structures can be fabricated on top and bottom side as well as around these inlays by etching the conductive structures and making connections by vias or through holes between the conductive layers. The vias can be filled with copper or other conductive materials to realize connections between the layers, forming coils and/or other structures.

Different materials may be used for those magnetic members or inlays. In particular, magnetic particles in a resin based matrix may be used. For instance, metal particles (such as flakes), ferrite particles, particles in resin based pastes (in terms of a binder system), etc., may be used. Appropriate materials may be selected in accordance with a specific application. Materials with magnetic particles in a polymer matrix proved particularly advantageous for many applications due to their intrinsic air gap. Such type of air gap may make the characteristic of inductance versus current bias stable. An additional advantage is that eddy currents can be significantly reduced due to the small size of the magnetic particles. Additionally, each magnetic particle can be surrounded with an isolation barrier (such as a dielectric coating) made of electrically isolating materials (for instance of an organic or inorganic material).

In terms of a first method, introducing the magnetic material into a PCB may be accomplished by embedding a pre-shaped inlay in the area where the magnetic properties are required. Alternatively, introduction may be carried out in a second method by introducing a continuous layer into the PCB build-up. The first method allows making electrical connections in the areas where no magnetic material is present. The second method may involve isolation of the conductive vias against the magnetic material. This can be achieved by drilling holes, filling with resin and drilling a smaller hole into the resin filler, which is subsequently plated and filled with conductive material (for instance copper). Another method may be to coat the walls of the hole by any other method with isolation material.

For some magnetic materials, it may be advantageous to provide additional isolation layers before the conductive layers are made in the build-up. Introduction of those isolation layers may be advantageous due to the low resistivity of the magnetic material. In particular, the following solutions can be realized in this context:
- Lamination with a polymer based resin sheet (polymer sheet without glass fibre reinforcement such as a bonding sheet), polymer sheet with glass fibre reinforcement (for instance prepreg), etc.
- Liquid or paste coating applied by spraying, printing, etc.

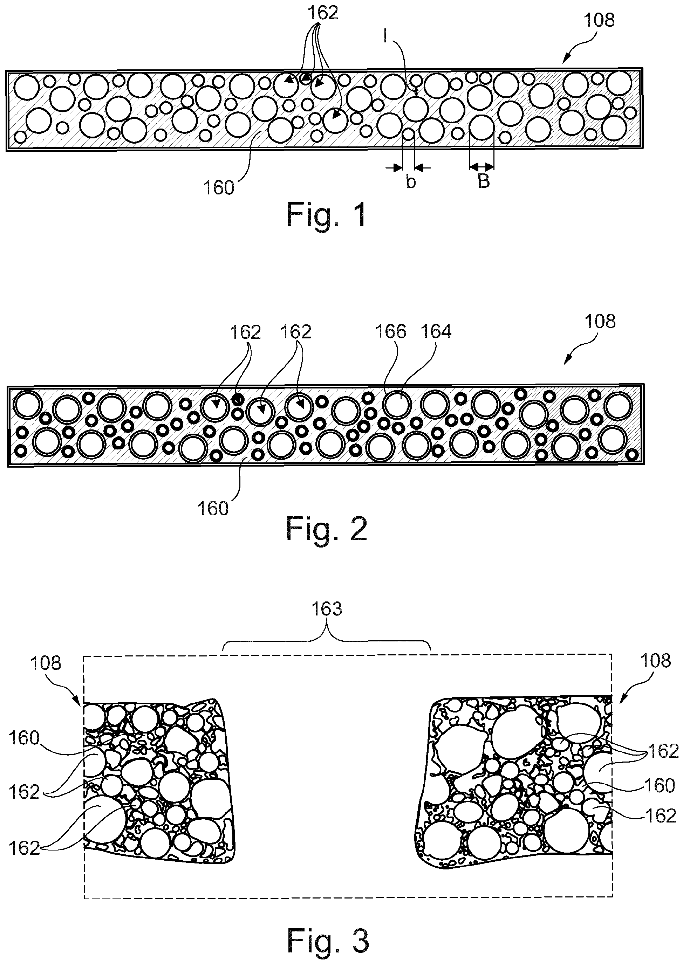

Figure 1 to Figure 3 illustrate different views of magnetic members 108 with magnetic particles 162 in the non-magnetic matrix 160 according to exemplary embodiments of the invention.

Referring to **Figure 1****,** a side view of a magnetic member 108 is shown. Although not derivable from Figure 1, the magnetic member 108 may be an annular or ring-like structure with a central through hole which is not visible in Figure 1. The annular structure of magnetic member 108 of Figure 1 comprises a non-magnetic matrix 160 and a large plurality of magnetic particles 162 (in particular at least 100, more particularly at least one thousand particles) embedded in the matrix 160.

The matrix 160 may be made of a solid electrically insulating and substantially non-magnetic material such as an epoxy resin or polyimide. The substantially non-magnetic property (i.e. having a relative magnetic permeability µᵣ very close to one) of the matrix 160 ensures that the matrix material effectively functions as non-magnetic gap maintaining a spacing between the magnetic particles 162 having pronounced magnetic properties and thus high values of the relative magnetic permeability µᵣ. The dielectric property of the matrix 160 does not only form an intrinsic non-magnetic gap in an interior of the substantially annular body, but also ensures advantageously that no undesired electrically conductive paths are formed when the magnetic member 108 is coupled with an electronic periphery, for instance is embedded in a component carrier 100, as shown for instance in Figure 7 to Figure 16 or Figure 25 to Figure 47.

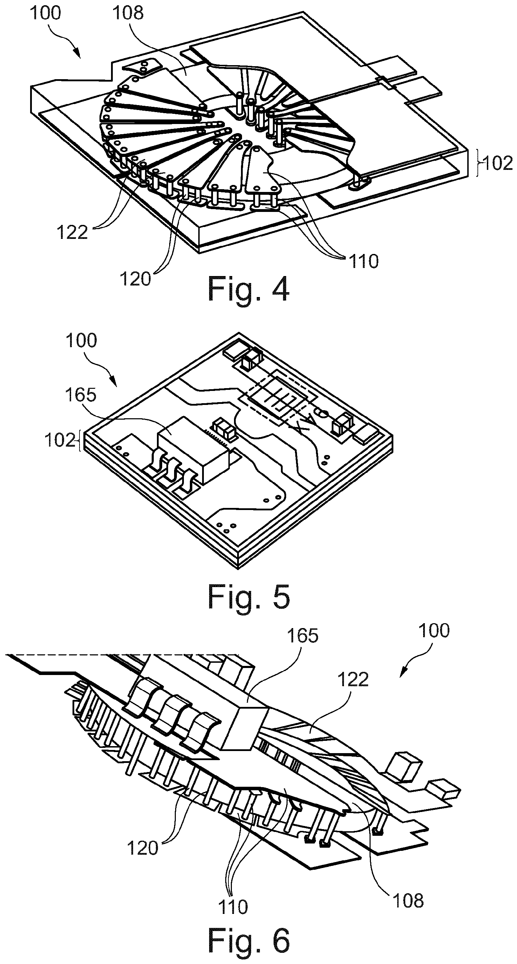

For example, the magnetic particles 162 may be made of a ferrite or a metal oxide. Other materials, such as iron-based materials with silicon additive are possible as well. For instance, the relative magnetic permeability µᵣ of the magnetic particles 162 may be 1,000. Thus, the magnetic particles 162 have the capability of strongly enhancing an external magnetic field, which may for instance be generated by a powered coil structure 110, see Figure 4. In view of these properties, magnetic member 108 according to Figure 1 is highly appropriate for applications such as inductors, wireless charges, transformers, etc. Preferably, the magnetic particles 162 are magnetically stable at least up to 260°C. In other words, the magnetic particles 162 may be configured for withstanding temperatures which may occur for instance during lamination processes in terms of component carrier technology. In view of this property, the magnetic member 108 is highly suitable for being embedded in a laminate-type component carrier 100.

As shown in Figure 1 as well, the magnetic particles 162 are spaced with respect to each other by material of the matrix 160 in between. As a result, the resin spacers in form of material of matrix 160 between adjacent magnetic particles 162 form permanent dielectric microscopic gaps having an impact on the magnetic performance of the magnetic member 108.

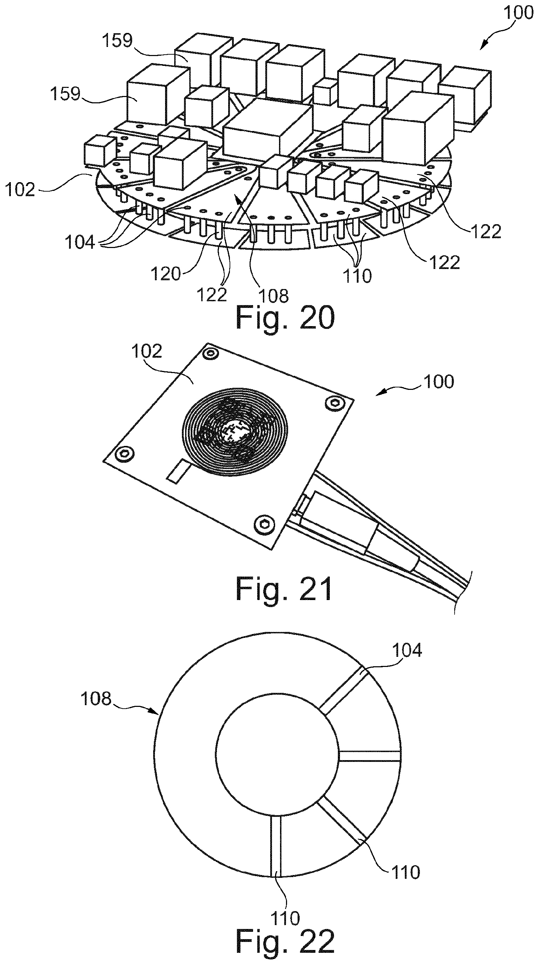

For instance, the annular structure of the magnetic member 108 may be free of macroscopic gaps, for example as in Figure 22. In such an embodiment, the adjustment of the magnetic properties of the magnetic member 108 (in particular its magnetic saturation properties) can be accomplished by adjusting the relative amounts of material of matrix 160 and material of magnetic particles 162, as well as dimensions of the particles 160 and of the microscopic gaps. For instance, typical diameters of the magnetic particles 162 may be b=5 µm or B=15 µm. For example, a typical distance between neighboured magnetic particles 162 may be 1=5 µm.

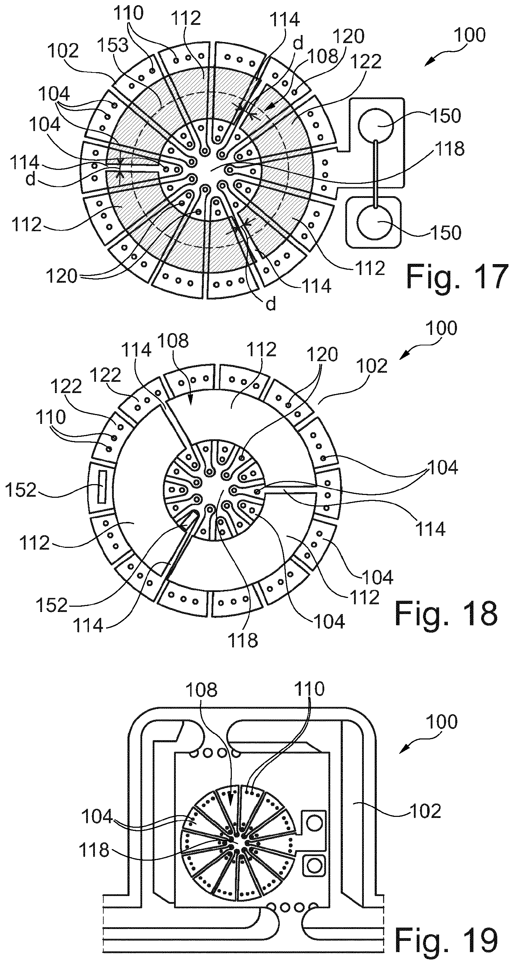

Alternatively, the annular structure may have one or more macroscopic air gaps 114, for example as in Figure 18. The adjustment of the magnetic properties of the magnetic member 108 and in particular of its saturation properties may then be made by adjusting the number and width d (see Figure 17) of macroscopic air gaps 114 and/or by adjusting the properties of the microscopic gaps, as described in the preceding paragraph.

The geometric configurations with or without macroscopic gaps allow the formation or generation of a circumferentially closed magnetic field substantially in an interior of the magnetic member 108.

In particular, the magnetic member 108 may be used for adjusting magnetic properties of a component carrier 100 in which the magnetic member 108 is embedded. In such a context, the magnetic properties may be adjusted by adjusting an amount of material of the magnetic particles 162 and of the matrix 160, a size (b, B) of the magnetic particles 162, and/or a mutual distance (I) between the magnetic particles 162 in the matrix 160.

As shown in Figure 1, substantially an entire exterior surface of the substantially annular structure is electrically insulating. In other words, the exterior surface of the illustrated magnetic member 108 is entirely dielectric, so that no artificial electrically conductive paths are formed between the magnetic member 108 and an environment.

Referring to **Figure 2****,** a side view of another magnetic member 108 is shown. The configuration of Figure 2 may be correspondingly as described for Figure 1. However, according to Figure 2, each of the magnetic particles 162 comprises a magnetic core 164 and an electrically insulating shell 166 covering or coating the magnetic core 164. By taking this measure, it can be prevented that magnetic particles 162, when made of an electrically conductive material, form undesired electrically conductive paths in an electronic periphery (for instance when embedded in a stack 102 of a component carrier 100).

Referring to **Figure 3****,** a cross-sectional view of an annular magnetic member 108 with a central through hole 163 (which may for instance be filled with resin material or a platelet, such as the one described below referring to reference sign 118) according to another exemplary embodiment of the invention is shown. According to Figure 3, the size of the particles 162 varies over a broader range. In other words, the magnetic particles 162 of Figure 3 have a size distribution.

All magnetic members 108 described below referring to Figure 4 to Figure 47 may comprise a non-magnetic matrix 160 with magnetic particles 162 embedded therein, for instance as illustrated in Figure 1 to Figure 3.

Figure 4 to Figure 6 illustrate cross-sectional views of transformers produced using magnetic member 108 and coil structures 110 according to exemplary embodiments of the invention. The magnetic member 108 may be embedded in a stack 102 of a component carrier 100.

Referring to **Figure 4****,** the magnetic member 108 is shown alone, i.e. without stack 102. Referring to **Figure 5****,** the magnetic member 108 is shown embedded in a stack 102. Referring to **Figure 6****,** the illustrated magnetic member 108 is shown together with a surface mounted component 165.

Figure 4 and Figure 6 show that the annular structure composed of matrix 160 and magnetic particles 162 can be surrounded by electrically conductive structures of an electrically conductive coil structure 110. The coil structure 110 is composed by cooperating vertical segments 120 and horizontal segments 122, as described below in further detail.

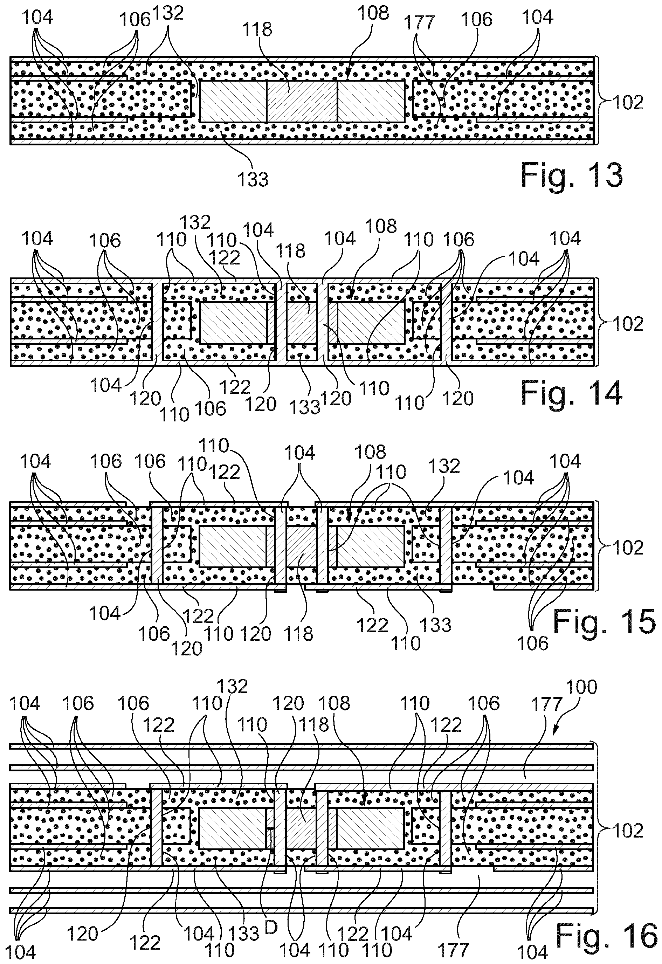

Figure 7 to Figure 16 illustrate cross-sectional views of structures obtained during manufacturing a component carrier 100 with an embedded magnetic member 108 and an intrinsically formed coil structure 110, shown in Figure 16, according to an exemplary embodiment of the invention.

**Figure 7** illustrates a cross-sectional view of a plate-shaped laminate-type layer stack 102, which may be a core. The laminated stack 102 is composed of electrically conductive layer structures 104 and an electrically insulating layer structure 106. For example, the electrically conductive layer structures 104 may comprise patterned copper foils (and optionally one or more vertical through connections, for example copper filled laser vias). The electrically insulating layer structure 106 may comprise a resin (such as epoxy resin), optionally comprising reinforcing particles therein (for instance glass fibers or glass spheres). For instance, the electrically insulating layer structure 106 may be made of prepreg or FR4. The layer structures 104, 106 may be connected by lamination, i.e. the application of pressure and/or heat.

Thus, Figure 7 illustrates the cross-section of a PCB (printed circuit board) core. The stack 102 is composed of a central electrically insulating layer structure 106 covered on both opposing main surfaces thereof with a respective patterned copper foil as electrically conductive layer structure 104.

Referring to **Figure 8****,** an opening 190 is formed in the stack 102. More specifically, opening 190 may be cut in the stack 102 shown in Figure 1. The formed opening 190 is later used for accommodating a magnetic member 108 to be embedded in the stack 102. For instance, the opening 190 may be formed by laser cutting, mechanically cutting or etching.

Referring to **Figure 9****,** a sticky layer 130 may be attached to a bottom of the stack 102 for closing the opening 190. According to Figure 9, the upper main surface of the sticky layer 130 is sticky or adhesive. As will be described below, the sticky layer 130 will function as a temporary carrier. For instance, the sticky layer 130 may be a sticky foil or a sticky plate. Since the opening 190 is closed at a bottom side by the sticky layer 130, a cavity is defined which has a volume corresponding to the opening 190 and is closed at the bottom side by the sticky layer 130. The exposed upper main surface of the temporary carrier shown in Figure 9 is adhesive.

Referring to **Figure 10** a magnetic member 108 (such as the one shown in Figure 1 to Figure 3) is subsequently attached on the sticky layer 130 and in the cavity of the stack 102. Said magnetic member 108 may be circumferentially closed or may comprise a plurality of separate segments (see for instance Figure 17 and Figure 18) which can be assembled separately on the sticky layer 130. In order to obtain the structure shown in Figure 10, the magnetic member 108 may be inserted into the opening 190 and may be adhered to the adhesive upper side of the sticky layer 130. This is particularly advantageous when the magnetic member 108 is composed of multiple separate bodies. Adhering the magnetic member 108 on the sticky side of the sticky layer 130 may define an exact position of the magnetic member 108 in the cavity. The magnetic member 108 or its separate bodies are thereby also prevented from sliding within the cavity. A dimension of gaps (see reference sign 114 in Figure 17 and Figure 18) between separate bodies of the magnetic member 108 may be used as a design parameter for precise controlling the characteristic of the component carrier 100 with embedded magnetic member 108. For instance, dimensioning of said gaps 114 may also fulfil the task of ensuring that the magnetic field in the annular magnetic member 108 does not go into saturation. Also the geometric properties of the constituents of the magnetic member 108, i.e. of matrix 160 and magnetic particles 162, may be used as design parameters for adjusting the magnetic saturation properties, functioning as intrinsic or microscopic gaps. Thus, multiple ring segments or other separate bodies constituting together the magnetic member 108 may be advantageous. However, placing multiple separate bodies constituting together the magnetic member 108 into the opening 190 might be conventionally an issue because of the risk of a slight sliding or motion of one or more of the individual bodies of the magnetic member 108. This may introduce artefacts into the magnetic behaviour of the magnetic member 108. However, by closing bottom of the stack 102 comprising the opening 190 with the sticky layer 130 and by subsequently adhering the individual bodies of the magnetic member 108 on the sticky layer 130 during an assembly process, it may be ensured that the individual bodies of the magnetic member 108 are located at well-defined positions and are brought in a well-defined orientation with respect to each other. Otherwise, a subsequently described method of manufacturing a coil structure 110 surrounding the magnetic member 108 may damage or even destroy the magnetic member 108. For instance, this may happen when mechanically drilling for defining the position of vertical through-connections, and hereby an erroneous drilling may occur also into material of erroneously positioned and/or oriented bodies of the magnetic member 108.

Still referring to Figure 10, a central opening 116 of the magnetic member 108 may be filled with a dielectric platelet 118, such as an FR4 platelet. This may ensure that only a small amount of adhesive material or of flowable resin material will be required during a lamination procedure described referring to Figure 11 to fill the small spaces between the platelet 118 and the magnetic member 108. The undesired formation of voids in an interior of the stack 102 may thus be reliably prevented. Hence, the described procedure may ensure a complete filling of the opening 190 with the magnetic member 108, the platelet 118 and the laminated dielectric material. Assembling the platelet 118 in the cavity and on the sticky layer 130 may be performed before, during or after assembling the magnetic member 108 on the sticky layer 130.

Referring to **Figure 11****,** the magnetic member 108 is fixed in place in the opening 190 by laminating adhesive material 132 onto a top side of the structure shown in Figure 10. Thus, after assembly of the magnetic member 108, a first lamination procedure may be carried out which is described referring to Figure 11. During this lamination, a further electrically conductive layer structure 104 and/or a further electrically insulating layer structure 106 is attached to the upper main surface of the arrangement shown in Figure 10 and is made subject to lamination. Preferably, the electrically insulating layer structure 106 attached to the upper side of the stack 102 may be made of an at least partially uncured dielectric such as a prepreg sheet. During the lamination process, heat and/or mechanical pressure is applied to the stack 102 to be connected. During this lamination, the material of the previously at least partially uncured dielectric material may become flowable or liquid and may flow into tiny gaps between the assembled magnetic member 108 and the sidewalls of the stack 102 as well as below the magnetic member 108 to fill also gaps here. During the lamination, said flowable material will cure and will be re-solidified so that the magnetic member 108 is then fixed in place.

As an alternative to the described lamination, it is also possible to apply liquid adhesive (for instance by dispensing or printing) into remaining empty spaces of the opening 190 and cure the liquid adhesive so that the magnetic member 100 is fixed in place.

Referring to **Figure 12****,** the sticky layer 130 may be optionally (for instance depending on the used sticky material) removed after completing the lamination. After the described lamination procedure, the temporary carrier, sticky film or positioning layer may thus be removed from the bottom side of the component carrier 100 to be manufactured. Since, as a result of the lamination procedure, the magnetic member 108 with its individual ring segments has been fixed in place at the correct position within the opening 190, the sticky layer 130 is no longer needed for providing support and defining assembly positions. It is thus removed to obtain a structure shown in Figure 12.

As shown in **Figure 13****,** the obtained structure may then be made subject to a second lamination procedure. This time, a further electrically conductive layer structure 104 and a further electrically insulating layer structure 106 may be laminated to the lower main surface of the structure of Figure 12. In the shown embodiment, the second lamination procedure is carried out so as to obtain a symmetric arrangement of the layer stack 102 in the vertical direction (if the sticky material remains connected to the stack 102, the arrangement of layers may be slightly asymmetric). As a result, further adhesive material 133 covers a bottom of the magnetic member 108.

The dielectric material added according to Figure 12 and/or Figure 13 can also include additives increasing the thermal conductivity and thereby forming a heat removal structure 177 for removing heat from the later formed coil structure 110 and/or the magnetic member 108. In other words, the magnetic component in form of the magnetic member 108 can be embedded in a resin based on a thermo-prepreg (which may have a heat conductivity in a range from 2 W/mK to 8 W/mK).

Referring to **Figure 14****,** the electrically conductive layer structures 104 are then trimmed so as to form an electrically conductive coil structure 110 surrounding the magnetic member 108. In order to obtain the structure shown in Figure 14, vertical drilling holes may be formed extending through the entire stack 102. Subsequently, said drilling holes, which may be formed by mechanically drilling, may be filled partially or entirely with electrically conductive material (such as copper) by plating. Thus, the obtained vertical through-connections may be hollow cylindrical or circular cylindrical structures of copper. The copper filled vertical through-holes may form vertical segments 120 of coil structure 110 being formed to surround the annular magnetic member 108 with a plurality of coil windings.

In order to obtain the structure shown in **Figure 15****,** the previously continuous metal foils (for instance copper foils) on the upper and lower main surface of the illustrated structure can be patterned so as to form horizontal segments 122 to complete the formation of closed loops or windings running circumferentially around the annular magnetic member 108. As a result, a plurality of closed windings is formed by the interconnection of the vertical segments 120 provided by the plated through-holes and the horizontal segments 122 provided by the patterned metal foils. The magnetic member 108 has a central opening (see reference sign 116 in Figure 10) through which part of the coil structure 110 extends. Another part of the coil structure 110 is arranged laterally exteriorly of the magnetic member 108. The coil structure 110 extends over a larger vertical range than the magnetic member 108. More specifically, the coil structure 110 protrudes vertically beyond the magnetic member 108 upwardly and downwardly.

Referring to **Figure 16****,** component carrier 100 according to an exemplary embodiment of the invention is obtained by further laminations both on the top side and the bottom side of the structure shown in Figure 15. In order to obtain the component carrier 100 shown in Figure 16, a further build-up may be carried out, i.e. one or more additional electrically conductive layer structures 104 and/or one or more additional electrically insulating layer structures 106 may be added on top and/or on bottom of the structure shown in Figure 15 by a further lamination procedure.

A heat removal structure 177 may be provided as part of the stack 102. It may be configured for removing heat from the coil structure 110 and/or the magnetic member 108. The heat removal structure 177 may comprises a metallic material and a thermally conductive prepreg (which may have a heat conductivity in a range from 2 W/mK to 20 W/mK, in particular in a range from 2 W/mK to 8 W/mK). Both of the laminated structures can be made out of a thermo-prepreg. In addition to that, a copper member can be mounted on the surface of the thermo-prepreg.

The illustrated laminate-type plate-shaped component carrier 100 may be embodied as a printed circuit board (PCB). The component carrier 100 comprises the stack 102 composed of the electrically conductive layer structures 104 and the electrically insulating layer structures 106. The magnetic member 108 is embedded in the stack 102. Part of the electrically conductive layer structures 104 form the integrally formed electrically conductive coil structure 110 surrounding the magnetic member 108. For instance, the magnetic member 108 may be made of a non-magnetic matrix 160 with magnetic particles 162 embedded therein. The magnetic member 108 may be embodied as a closed ring or as an open ring having a central opening 116 filled with the dielectric platelet 118, which may be preferably made of FR4. The dielectric platelet 118 forms part of the component carrier 100. Said coil structure 110 is composed of the vertical segments 120 and the horizontal segments 122 which are interconnected to form a plurality of windings. The vertical segments 120 may be formed as plated through-holes or slots filled with electrically conductive material. The horizontal segments 122 may lie in two parallel planes and may for instance comprise substantially triangular sub-sections being interconnected with the vertical segments 122 thereby forming coil windings surrounding the magnetic member 108. Still referring to Figure 16, a minimum distance D between the electrically conductive coil structure 110 and the magnetic member 108 may be advantageously larger than 10 µm and less than 30 µm.

Figure 17 to Figure 19 illustrate plan views of component carriers 100 according to exemplary embodiments of the invention.

Referring to **Figure 17****,** the magnetic member 108 is a ring structure composed of three ring segments 112 with three gaps 114 in between. A thickness d of different gaps 114 between ring segments 112 of the magnetic member 108 vary preferably less than 20%. Even more preferably, the multiple gaps 114 between adjacent ring segments 112 of the magnetic member 108 may have substantially the same length d.

The plan view of the magnetic member 108 with surrounding integrated coil structure 110 of Figure 17 shows that in this embodiment the magnetic member 108 is provided as a substantially annular body composed of three ring segments 112 with three gaps 114 in between. The coil structure 110 surrounding the magnetic member 108 comprises the substantially triangular circle sector type horizontal segments 122. Cylindrical vertical segments 120 are provided at a radially inner side of the horizontal segments 122 and at a radially outer side of the horizontal segments 122 and can thereby connect with the horizontal segments 122 to form windings of the coil structure with substantially rectangular geometry in a side view (compare Figure 16). Coil connections are denoted with reference numeral 150 in Figure 17.

Now referring to **Figure 18****,** a plan view of a magnetic member 108 surrounded by windings of the coil structure 110 of an exemplary embodiment of the invention is shown. As indicated with reference numeral 152, the vertical segments 120 with circular shape can be substituted and/or supplemented by slots filled with electrically conductive material such as copper and extending vertically to the paper plane of Figure 18. Descriptively speaking, it is for instance possible to combine multiple (in particular two or three) radially arranged and/or tangentially arranged circular vertical segments 120 to a single common vertical slot segment 152. This may provide a low ohmic configuration which increases the current carrying capability, reduces the generation of heat in an interior of the component carrier 100 and results in lower losses.

By providing a zigzag connection of horizontal segments 122 and vertical segments 120, closed windings of the coil structure may be created.

As can be derived from Figure 17 and Figure 18, a trajectory connecting centers of windings of the coil structure 110 is a circumferentially closed loop extending within a horizontal plane. Central axes of the windings of the coil structure 110 extend within a horizontal plane. This is indicated schematically in Figure 17 with a circle 153.

**Figure 19** shows the magnetic member 108 with coil structure 110 together with further constituents of a component carrier 100 according to an exemplary embodiment of the invention.

Figure 20 and Figure 21 illustrate three-dimensional views of component carriers 100 according to exemplary embodiments of the invention.

**Figure 20** shows a three-dimensional view of a component carrier 100 according to an exemplary embodiment of the invention with a number of components 159 which can be coupled to the described magnetic structure.

**Figure 21** shows a component carrier 100 configured as a wireless charger. What concerns the wireless charging function of the component carrier 100, applying an electric current to the coil structure 110 generates an electromagnetic field in the environment of the component carrier 100. The magnetic member 108 of very high magnetic permeability enhances the electromagnetic field. When a mobile phone or other electronic device to be charged in a wireless manner is positioned in an environment of the component carrier 100 and when such an electronic device comprises a corresponding receiver unit, the electromagnetic field generated by the component carrier 100 may be used for charging the electronic device.

Figure 22 to Figure 24 illustrate plan views of inductor structures which may be implemented in component carriers 100 according to exemplary embodiments of the invention.

In the embodiment of **Figure 22****,** the magnetic member 108 with surrounding coil structure 110 is embodied as a toroid structure. This has the advantage of a very low leakage flux.

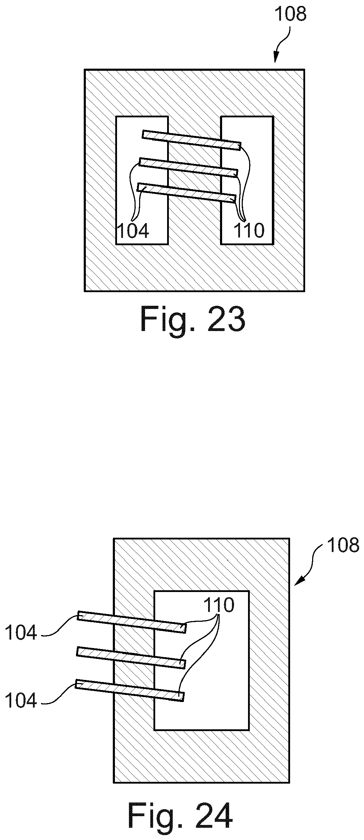

As shown in the embodiment of **Figure 23****,** an equal configuration is illustrated which is highly appropriate for coupled inductors. Moreover, such a configuration ensures a sufficiently large via spacing and a low leakage flux.

In the embodiment of **Figure 24****,** the magnetic member 108 has a core configuration with high via spacing and sufficient leakage flux.

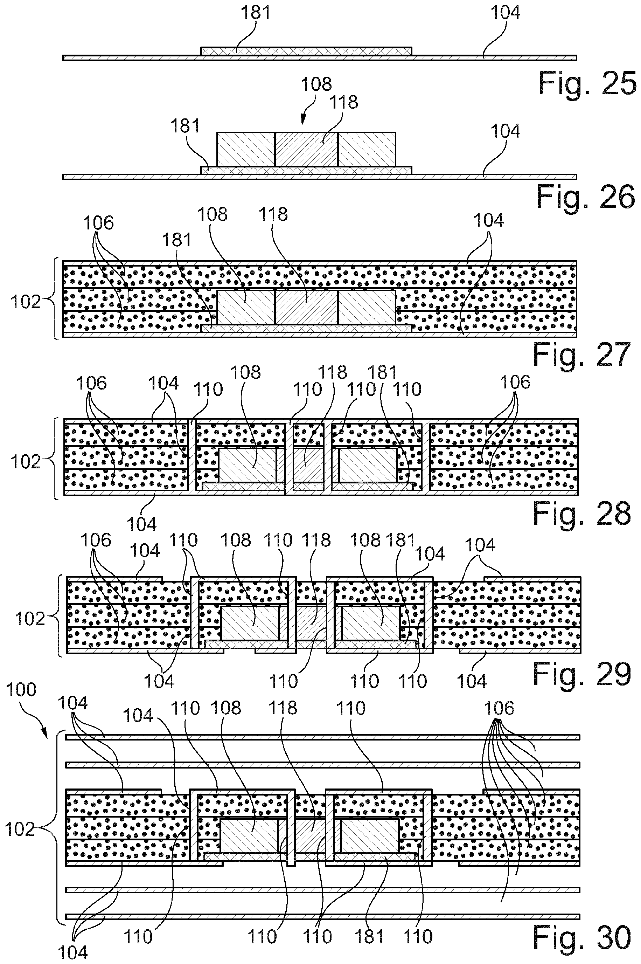

Figure 25 to Figure 30 illustrate cross-sectional views of structures obtained during manufacturing a component carrier 100, shown in Figure 30, with an embedded magnetic member 108 such as the one shown in Figure 1 to Figure 3 and an intrinsically formed coil structure 110 according to another exemplary embodiment of the invention.

Referring to **Figure 25****,** an adhesive structure 181 (such as an adhesive paste) may be applied in different ways, for instance may be printed, on an electrically conductive layer structure 104, in particular a copper foil.

Referring to **Figure 26****,** a magnetic member 108 may be assembled and adhered to the adhesive structure 181 on said electrically conductive layer structure 104.

Referring to **Figure 27****,** the magnetic member 108 may be covered with electrically insulating layer structures 106 and a further electrically conductive layer structure 104. The electrically insulating layer structures 106 at lower levels may be provided with a through hole or a blind hole for accommodating the magnetic member 108 in said holes. More specifically, the magnetic member 108 may be laminated with cut-out prepreg layers. If at least one of said electrically insulating layer structures 106 is at least partially uncured (for instance is in a B-stage), no adhesive paste is needed in addition, since the constituents of the structure shown in Figure 27 may be connected with each other by lamination, i.e. the application of heat and/or pressure.

Referring to **Figure 28****,** constituents of an electrically conductive coil structure 110 may be formed, for instance by drilling and plating.

Referring to **Figure 29****,** a structure is shown which is obtained by patterning electrically conductive layer structures 104 on both opposing main surfaces of the structure shown in Figure 28.

Referring to **Figure 30****,** additional electrically conductive layer structures 104 and electrically insulating layer structures 106 are added on both opposing main surfaces of the structure shown in Figure 29, to thereby complete manufacture of component carrier 100.

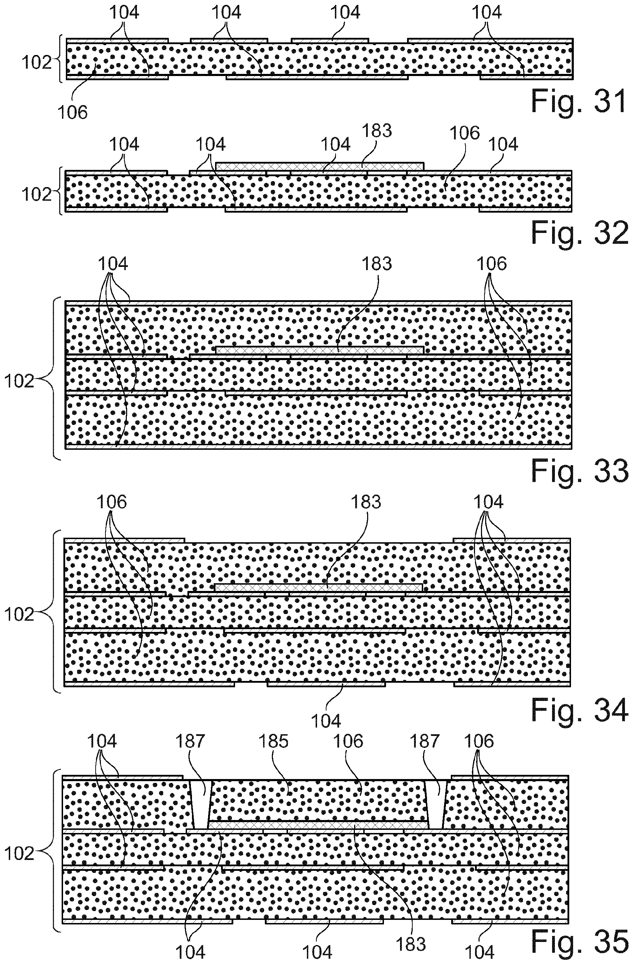

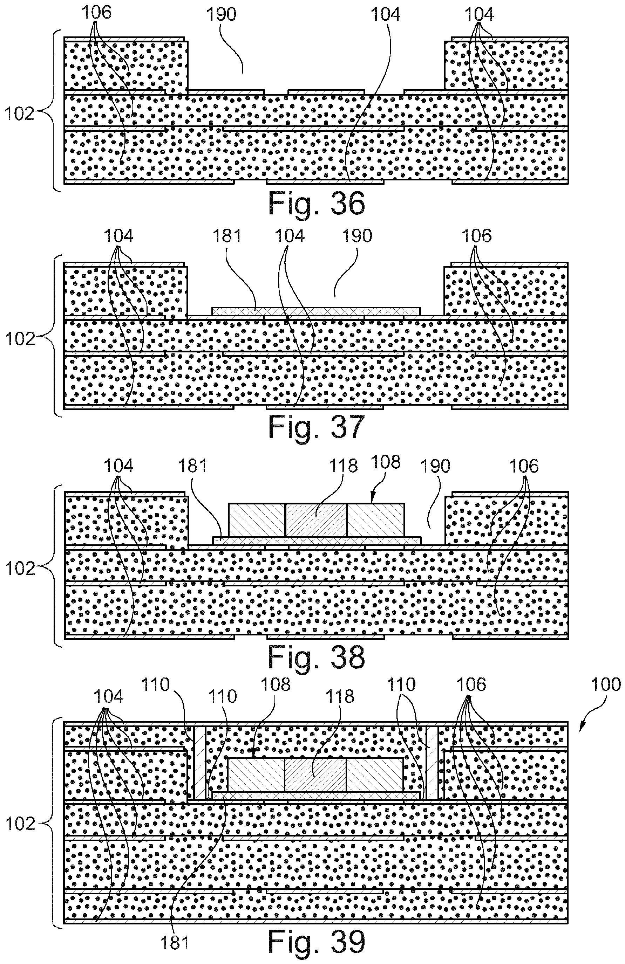

Figure 31 to Figure 39 illustrate cross-sectional views of structures obtained during manufacturing a component carrier 100 with an embedded magnetic member 108 (which may be configured as described referring to Figure 1 to Figure 3) and an intrinsically formed coil structure 110, shown in Figure 39, according to another exemplary embodiment of the invention.

Referring to **Figure 31****,** a stack 102 composed of a central electrically insulating layer structure 106 and patterned electrically conductive layer structures 104 on both opposing main surfaces thereof is shown. For instance, stack 102 may be embodied as PCB (printed circuit board) core.

Referring to **Figure 32****,** a release layer 183 is formed at a surface of the stack 102. For instance, the release layer 183 may be printed in form of a waxy compound on the upper main surface of the stack 102 shown in Figure 91. Thus, the release layer 183 may be made of a material being poorly adhesive with respect to other materials of stack 102.

Referring to **Figure 33****,** further electrically conductive layer structures 104 and electrically insulating layer structures 106 may be connected to both the upper main surface and the lower main surface of the structure shown in Figure 92 to thereby embed the release layer 183 within the stack 102.

Referring to **Figure 34****,** previously continuous electrically conductive layer structures 104 on both opposing main surfaces of the structure illustrated in Figure 33 are patterned.

Referring to **Figure 35****,** a circumferential cutting trench 187 is cut in the stack 102 to extend vertically up to the release layer 183. Cutting trench 187 may for example be formed by laser cutting or by mechanically cutting. Thereby, a stack piece 185 is separated from a rest of the stack 102. Laterally, piece 185 is separated by the cutting trench 187. At a bottom side, piece 185 is separated by the non-adhesive release layer 183.

Referring to **Figure 36****,** a blind hole-type opening 190 is formed in the stack 102 by removing said cap-shaped piece 185 from the stack 102. As shown, piece 185 is delimited at a bottom side by the release layer 183 and laterally by the circumferential or annular trench 187. Thereafter, the release layer 183 may be removed, for instance by stripping.

Referring to **Figure 37****,** an adhesive structure 181 is formed at a bottom surface of the blind hole-type opening 190. For instance, a layer of an adhesive material may be printed with a stencil. However, adhesive material can also be applied differently than printing, in particular either to the bottom surface of the cavity or to the downward-facing surface of the magnetic member 108 to be attached to or assembled in the cavity.

Referring to **Figure 38****,** a magnetic member 108 is mounted on the bottom surface in the opening 190 with the adhesive structure 181 in between. In other words, the magnetic member 108 may be assembled and accommodated in the opening 190.

Referring to **Figure 39****,** one or more further electrically conductive layer structures 104 and electrically insulating layer structures 106 may be laminated on top of the structure shown in Figure 38 to thereby embed the magnetic member 108 within an interior of the stack 102.

Although not shown in detail, it is subsequently possible to create electrically conductive structures by drill and via technology, thereby forming electrically conductive coil structure 110. Reference is made to the description of Figure 14 to Figure 16.

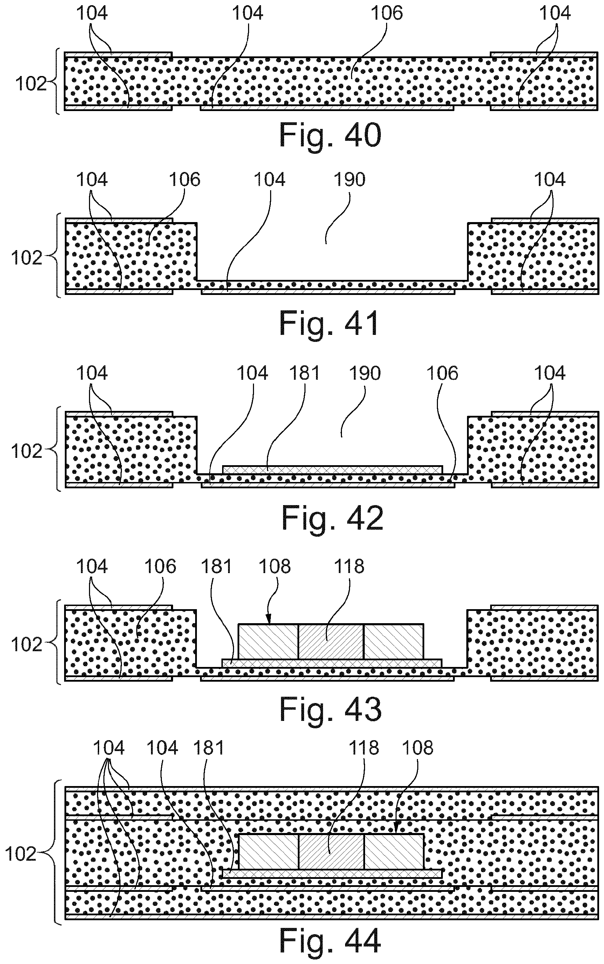

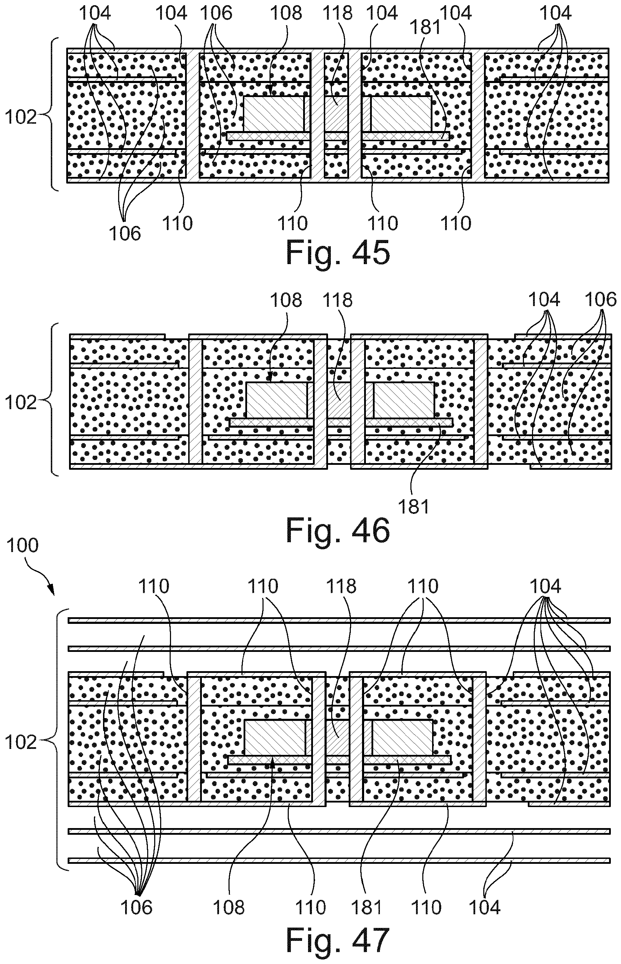

Figure 40 to Figure 47 illustrate cross-sectional views of structures obtained during manufacturing a component carrier 100 (shown in Figure 47) with an embedded magnetic member 108 (for instance having properties as described above referring to Figure 1 to Figure 3) and an intrinsically formed coil structure 110 according to another exemplary embodiment of the invention.

Referring to **Figure 40****,** starting point of the manufacturing process may be a PCB-core as stack 102, which may be constituted for instance in a similar way as shown in Figure 1 or Figure 31.

Referring to **Figure 41****,** a blind hole-type opening 190 is formed with a closed bottom side in the stack 102 by depth routing.

Referring to **Figure 42****,** an adhesive structure 181 is formed on a bottom surface delimiting opening 190. For instance, said adhesive material may be applied by stencil printing.

Referring to **Figure 43****,** a magnetic member 108 is assembled on the bottom surface with the adhesive structure 181 in between. In other words, the magnetic member 108 is accommodated on a bottom surface of the routed stack 102 in the opening 190.

Referring to **Figure 44****,** one or more further electrically conductive layer structures 104 and electrically insulating layer structures 106 may be laminated on top and on bottom of the structure shown in Figure 103 to thereby embed the magnetic member 108 in an interior of the stack 102.

Referring to **Figure 45****,** a portion of electrically conductive coil structure 110 is formed by a drill and fill process.

Referring to **Figure 46****,** the obtained structure is patterned.

Referring to **Figure 47****,** one or more further electrically conductive layer structures 104 and electrically insulating layer structures 106 may be laminated on top and on bottom of the structure shown in Figure 106, to thereby complete manufacture of component carrier 100.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A magnetic member (108) having a substantially annular structure and comprising a non-magnetic matrix (160) and magnetic particles (162) embedded in the matrix (160).

2. The magnetic member (108) according to claim 1, comprising at least one of the following features:
wherein the matrix (160) is electrically insulating;
wherein the matrix (160) is diamagnetic;
wherein the relative magnetic permeability µᵣ of the matrix (160) is in a range from 0.999 to 1.001;
wherein the matrix (160) comprises or consists of at least one of the group consisting of a temperature stable polymer, a resin , in particular an epoxy resin, and polyimide;
wherein the matrix (160) is solid and/or liquid;
wherein the magnetic particles (162) are at least one of the group consisting of ferromagnetic, ferrimagnetic, permanent magnetic, soft magnetic, a ferrite, a metal oxide, and an iron alloy, in particular alloyed silicon;
wherein the relative magnetic permeability µᵣ of the magnetic particles (162) is in a range from 2 to 1,000,000;
wherein the magnetic particles (162) are magnetically stable at least up to 200°C, in particular at least up to 260°C;
wherein at least part of the magnetic particles (162) is, in particular at least 50% of the magnetic particles (162) are, spaced with respect to each other without direct physical contact with other magnetic particles (162), and with material of the matrix (160) in between adjacent ones of said spaced magnetic particles (162);
wherein at least part of the magnetic particles (162) comprises a magnetic core (164) and an electrically insulating shell (166) covering the magnetic core (164);
wherein substantially an entire exterior surface of the substantially annular structure is constituted by electrically insulating material;
configured for generating a circumferentially closed magnetic field substantially in an interior of the magnetic member (108);
wherein the substantially annular structure is free of air gaps;
wherein the substantially annular structure has at least one air gap (114), in particular a plurality of circumferentially distributed air gaps (114).

3. The magnetic member (108) according to any of claims 1 to 2, comprising an electrically conductive coil structure (110) at least partially surrounding the substantially annular structure.

4. A component carrier (100), wherein the component carrier (100) comprises:
a stack (102) comprising at least one electrically conductive layer structure (104) and/or at least one electrically insulating layer structure (106); and
a magnetic member (108) according to any of claims 1 to 3 assembled to the stack (102).

5. The component carrier (100) according to claim 4, wherein the magnetic member (108) is surface mounted on the stack (102).

6. The component carrier (100) according to claim 4 or 5, wherein the magnetic member (108) is embedded in the stack (102).

7. The component carrier (100) according to any of claims 4 to 6, comprising an electrically conductive coil structure (110) at least partially surrounding the magnetic member (108) and being arranged at least partially within the stack (102).

8. The component carrier (100) according to claim 7, wherein the at least one electrically conductive layer structure (104) forms at least part of the coil structure (110).

9. The component carrier (100) according to claim 7 or 8, wherein the coil structure (110) comprises a plurality of vertical segments (120) and a plurality of horizontal segments (122) connected to form a plurality of windings.

10. The component carrier (100) according to claim 9, comprising at least one of the following features:
wherein the vertical segments (120) comprise plated through-holes and/or slots filled with electrically conductive material;
wherein the horizontal segments (122) are located in two parallel planes between which the vertical segments (120) are connected;
wherein the horizontal segments (122) extend radially outwardly with respect to a common centre;
wherein the horizontal segments (122) are substantially triangular.

11. The component carrier (100) according to any of claims 4 to 10, wherein the component carrier (100) is configured as one of the group consisting of an inductor, a wireless charger, a transformer, a DC/DC converter, an AC/DC inverter, a DC/AC inverter and an AC/AC converter.

12. The component carrier (100) according to any of claims 4 to 11, comprising at least one of the following features:
the component carrier (100) comprises a plurality of magnetic members (108) according to any of claims 1 to 15, each magnetic member (108) being embedded in a respective one of multiple stacked cores of the stack (102);
wherein at least one of the electrically conductive layer structures (104) comprises at least one of the group consisting of copper, aluminum, nickel, silver, gold, palladium, and tungsten, any of the mentioned materials being optionally coated with supra-conductive material such as graphene;
wherein the at least one electrically insulating layer structure (106) comprises at least one of the group consisting of resin, in particular reinforced or non-reinforced resin, for instance epoxy resin or bismaleimide-triazine resin, FR-4, FR-5, cyanate ester resin, polyphenylene derivate, glass, prepreg material, polyimide, polyamide, liquid crystal polymer, epoxy-based build-up film, polytetrafluoroethylene, a ceramic, and a metal oxide;
wherein the component carrier (100) is shaped as a plate;
wherein the component carrier (100) is configured as one of the group consisting of a printed circuit board, a substrate, and an interposer;
wherein the component carrier (100) is configured as a laminate-type component carrier (100).

13. A method of manufacturing a magnetic member (108), wherein the method comprises:
embedding magnetic particles (162) in a non-magnetic matrix (160); and
shaping the magnetic member (108) so as to form a substantially annular structure.

14. A method of using a magnetic member (108) according to any of claims 1 to 3 for adjusting magnetic properties of a component carrier (100).

15. The method according to claim 14, wherein the method comprises adjusting the magnetic properties by adjusting an amount of the magnetic particles (162) and/or an amount of the matrix (160), a size of the magnetic particles (162), and/or a mutual distance between the magnetic particles (162) in the matrix (160).
